(19) Europäisches Patentamt

European Patent Office

Office européen des brevets

(11) **EP 0 969 596 B1**

(12) **EUROPEAN PATENT SPECIFICATION**

(45) Date of publication and mention
of the grant of the patent:
**31.03.2004 Bulletin 2004/14**

(51) Int Cl.⁷: **H03H 7/25**

(21) Application number: **99304844.6**

(22) Date of filing: **21.06.1999**

(54) **Variable attenuation circuit**

Einstellbares Dämpfungsglied

Circuit d'atténuation variable

(84) Designated Contracting States:
**DE ES FR GB IT NL SE**

(30) Priority: **29.06.1998 JP 18246498**

(43) Date of publication of application:
**05.01.2000 Bulletin 2000/01**

(73) Proprietor: **HARADA INDUSTRY CO., LTD.
Shinagawa-ku Tokyo (JP)**

(72) Inventor: **Hashimoto, Michihiko
Asahi-ku, Yokohama-shi, Kanagawa-ken (JP)**

(74) Representative: **Butcher, Ian James et al
A.A. Thornton & Co.
235 High Holborn
London WC1V 7LE (GB)**

(56) References cited:
**DE-A- 2 937 020        US-A- 3 346 805**

**Description**

The present invention relates to a variable attenuation circuit favorably applied to an amplifier with AGC (automatic gain control) inserted in an antenna circuit of an on-vehicle antenna apparatus.

Since an excessive reception signal of an antenna is supplied to a tuner in a strong electric field, a distortion (especially tertiary intermodulation distortion) occurs in the tuner to lower the reception performance of the antenna. As one measure against this, a reception signal having a fixed level or higher is prevented from being input to the tuner by interposing an amplifier with an AGC circuit between the antenna and tuner. This measure improves the reception performance to some extent since a reception signal having a fixed level or higher is not input to the tuner.

However, the conventional amplifier with an AGC circuit has a problem in which a variable attenuation circuit, which is one constituting element of the AGC circuit, causes a large distortion upon receiving a strong signal. Therefore, the conventional amplifier has not been markedly improved in reception performance.

An object of the present invention is to provide a variable attenuation circuit which reduces a distortion generated by a strong input signal and improves in intermodulation distortion characteristics.

US 3,346,805 discloses a variable attenuation circuit comprising input and output terminals and a junction between the terminals, a first diode connected between the input terminal and the junction and a second diode connected between the junction and a ground, the diodes having opposite electrodes connected to the junction. A reverse bias is applied to the first diode, and a variable control voltage is applied to the junction to vary the bias potential across the diodes, and attenuate an input signal.

To resolve the above problem and attain the above object, the variable attenuation circuit of the present invention is constituted as follows.

The present invention provides a variable attenuation circuit comprising: a first diode connected between an input terminal and an output terminal such that a cathode side thereof is directed to the output terminal; a resistance element connected in series to a high-frequency capacitor, and both being connected in parallel to the first diode; a second diode connected between the cathode of the first diode and the ground through a capacitor such that a cathode side thereof is directed to the ground; a circuit for applying a control voltage so as to variably attenuate a signal level of the output terminal by varying the on-resistance of the first and second diodes; and a third diode connected in series to the second diode through a further resistance element.

In above-mentioned variable attenuation circuit, preferred features are as follows.

    (1) The third diode is a silicon diode.

(2) Each of the first and second diodes is a PIN diode.
(3) The first diode includes at least two diodes connected in series.
(4) The third diode includes one of at least two diodes and at least two Zener diodes.
(5) When the on-resistance of the first diode is $\Omega D1$, off-resistance thereof is $\Omega D2$, and resistance of the resistance element is $\Omega R1$, the following relationship is satisfied: $\Omega D1 << \Omega R1 < \Omega D2$.

According to the present invention, a first (PIN) diode is connected to a first resistance element in parallel through a high-frequency capacitor, and the first and second (PIN) diodes constitute an L-shaped attenuator to decrease an amplitude of a signal applied to an anode of the second (PIN) diode. Furthermore, the second (PIN) diode is connected to a general-purpose silicon diode in series through a second resistance element. Since the first (PIN) diode is greatly reverse-biased when a strong signal is input, the self-rectification of the first (PIN) diode is suppressed and the amount of bias variation attenuation is reduced. Consequently, the present invention can provide a variable attenuation circuit which reduces the distortion generated by a strong input signal and improves in intermodulation distortion characteristics.

It will be appreciated that preferred embodiments of the invention may include a sub-combination of the above-described preferred features.

The invention can be more fully understood from the following detailed description when taken in conjunction with the accompanying drawings, in which:

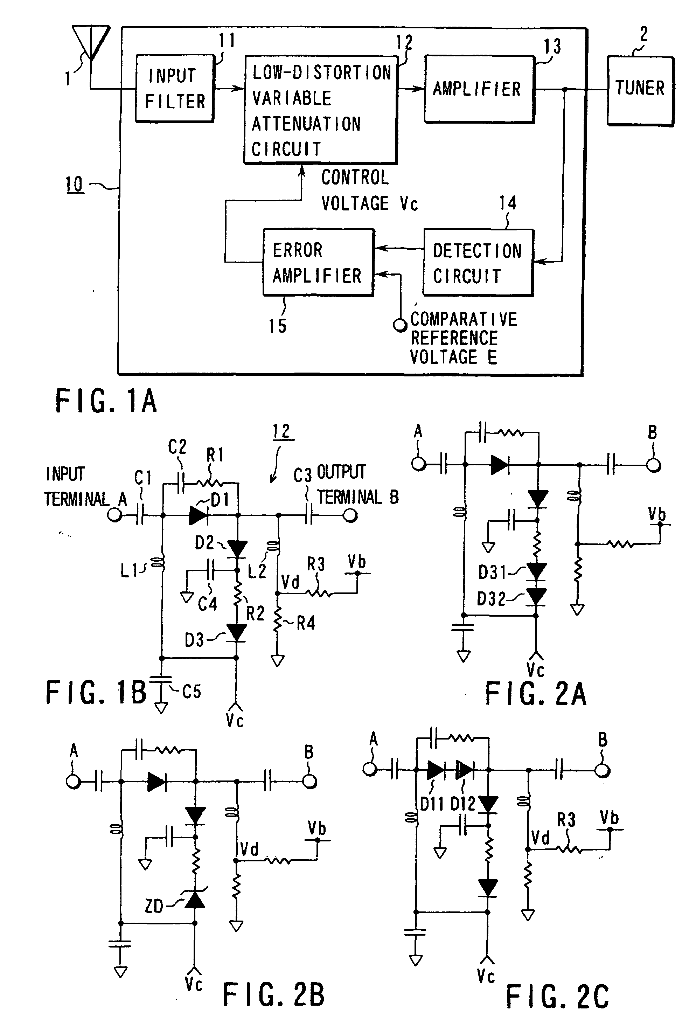

    FIGS. 1A and 1B show a variable attenuation circuit according to a first embodiment of the present invention, FIG. 1A is a block diagram schematically, showing the constitution of an amplification apparatus with on-vehicle AGC having the variable attenuation circuit, and FIG. 1B is a circuit diagram illustrating the arrangement of the variable attenuation circuit;

FIGS. 2A to 2C are circuit diagrams illustrating the arrangements of variable attenuation circuits according to second to fourth embodiments of the present invention; and

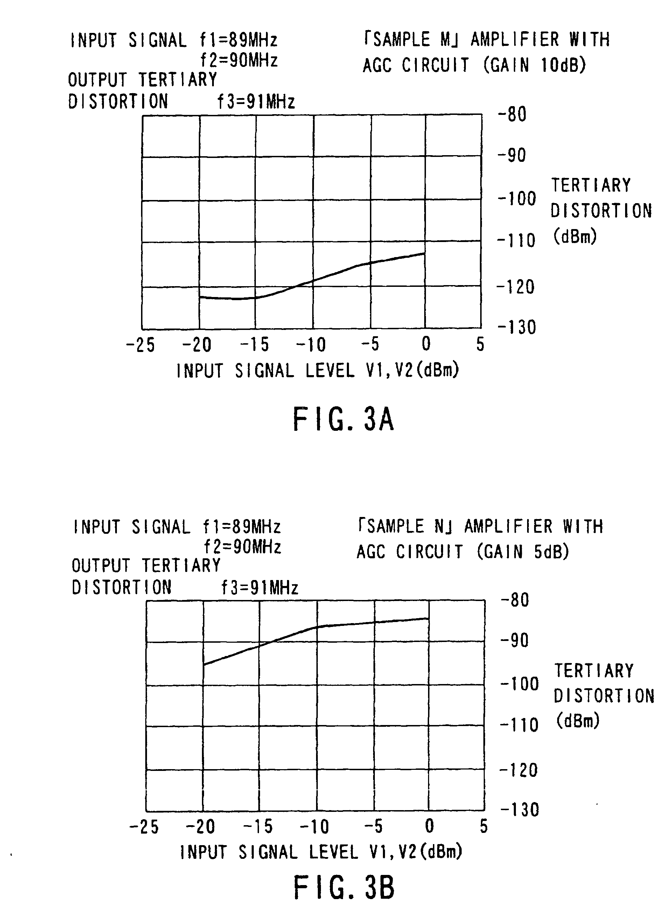

FIGS. 3A and 3B are graphs showing results of experiments on the variable attenuation circuits according to the embodiments of the present invention, in which FIG. 3A shows results of actual measurement of tertiary distortion of "sample M" with the feature of the present invention, and FIG. 3B shows results of actual measurement of tertiary distortion of "sample N" without the feature of the present invention,

(First Embodiment)

[Constitution]

FIG. 1A illustrates the constitution of an amplification apparatus 10 with on-vehicle AGC having a variable attenuation circuit according to a first embodiment of the present invention. The amplification apparatus 10 is interposed between an antenna 1 and a tuner 2 and includes an input filter 11 for receiving a signal from the antenna 1, a low distortion variable attenuation circuit 12, an output amplifier 13 for outputting a signal to the tuner 2, a detection circuit 14, and an error amplifier 15.

The output signal of the amplifier 13 is detected by the detection circuit 14 and compared with a comparative reference voltage E by the error amplifier 15. A difference between them is amplified and fed back to the variable attenuation circuit 12 as a control voltage Vc.

FIG. 1B is a circuit diagram specifically showing the arrangement of the low distortion variable attenuation circuit 12. As illustrated in FIG. 1B, the circuit 12 includes a first PIN diode D1 and a second PIN diode D2. The first PIN diode D1 is connected between an input terminal A and an output terminal B such that the cathode side thereof is directed to the output terminal B. The second PIN diode D2 is connected between the cathode of the first PIN diode D1 and the ground through a capacitor C4 such that the cathode side thereof is directed to the ground. The variable attenuation circuit 12 also includes a circuit for applying a control voltage Vc so as to variably attenuate a signal level of the output terminal B by varying on-resistance of the first and second PIN diodes D1 and D2. In the foregoing arrangement, the first and second diodes are PIN diodes. The present invention is not limited to this, but a diode having a function similar to that of the PIN diode can be employed. Hereinafter, however, only the use of the PIN diode will be described as a preferred embodiment.

A first resistance element R1 is connected in parallel to the first PIN diode D1 through a high-frequency capacitor C2, and the first and second PIN diodes D1 and D2 constitute an L-shaped attenuator. A general-purpose silicon diode D3 is connected in series to the second PIN diode D2 through a second resistance element R2, and the first PIN diode D1 is reverse-biased greatly when a strong signal is input.

FIG. 1B illustrates coupling capacitors C1 and C3, bypass capacitors C4 and C5, and high-frequency choke coils L1 and L2. FIG. 1B also illustrates partial-pressure resistance elements R3 and R4, a direct voltage Vb, and a divided voltage Vd.

[Operation and Function]

An operation of the amplification apparatus 10 and low distortion variable attenuation circuit 12 shown in FIGS. 1A and 1B will be described specifically. In a weak electric field, the level of a signal input to the apparatus 10 from the antenna 1 is low. The error amplifier 15 controls a control voltage Vc so as to cause an input signal to pass through the low distortion variable attenuation circuit 12 without attenuating the input signal. More specifically, when the control voltage Vc becomes higher than the sum of the divided voltage Vd and a dropped voltage (about 0.7V) of the PIN diode in its forward direction

$$Vc > Vd + about\ 0.7V,$$

the PIN diode D1 of the circuit 12 is turned on, and a signal applied to the input terminal A is hardly attenuated but output from the output terminal B. The resistance element R1 is connected in parallel to the PIN diode D1 in a high-frequency manner. If the value of the resistance element R1 is greatly larger than the on-resistance of the PIN diode D1, that is, if the resistance element satisfies the following relationship:

$$(resistance\ of\ R1 >> on\text{-}resistance\ of\ D1),$$

the influence of the resistance element R1 can be ignored.

Since, in this case, the PIN diodes D2 and D3 are reverse-biased, they are turned off and have a high impedance. Therefore, the PIN diodes exert no effect on the circuit operation.

When an electric field is strengthened and an output of the detection circuit 14 starts to exceed the comparative reference voltage E, the error amplifier 15 increases an amount of attenuation of the low distortion variable attenuation circuit 12 and controls the control voltage Vc so as to keep an output level of the amplifier 13 at a set value.

Assume that the low distortion variable attenuation circuit 12 includes no resistance element R1. In order to keep the output level of the amplifier 13 at a fixed value when the electric field is strengthened as described above, the control voltage Vc is brought close to the divided voltage Vd, the current flowing through the PIN diode D1 is reduced, and the on-resistance of the PIN diode D1 is increased. In this case, the PIN diodes D2 and D3 are not biased but turned off and still have a high impedance. The amount of attenuation is therefore determined by a ratio of the resistance of the PIN diode D1 and the input impedance (usually, designed as 50Ω or 75Ω) of the amplifier 13.

It is known that the control voltage Vc applied to the anode of the PIN diode D1 is varied within the following range and, when the flowing current is variably controlled, the resistance of the PIN diode D1 varies within a wide range between several ohms (Ω) and several kiloohms (kΩ).

$$Vd \leqq Vc \leqq (Vd + \text{about } 0.7V)$$

The attenuation of an attenuator having a resistance of the PIN diode D1 and an input impedance of the amplifier 13 ranges from about 20 dB to 30 dB, and the attenuator functions as a variable attenuation circuit.

When an electric field is strengthened, an AGC operation for keeping an output level of the amplifier 13 at a fixed value utilizing a wide range of variations in resistance of the PIN diode can be performed for about 20 dB to 30 dB increase in the input level from the start level of the AGC operation.

However, the above circuit including no resistance element R1 has a drawback in which a distortion generated from the PIN diode D1 is abruptly increased since the current flowing through the PIN diode D1 reduces as the control voltage Vc is brought close to the divided voltage Vd. The distortion to be generated greatly depends upon the input signal level. The above drawback can thus be resolved by designing a circuit arrangement in which the control voltage Vc is brought close to the divided voltage Vd upon receiving a low-level signal which reduces the distortion.

In the first embodiment, a resistance element R1 is selected so as to satisfy the relationship "on-resistance of D1 << resistance of R1 < off-resistance of D1", and it is connected in parallel to the PIN diode D1 through the coupling capacitor C2. If the attenuation circuit includes the resistor element R1, when the control voltage Vc applied to the anode of the PIN diode D1 is varied within the same range, $Vd \leqq Vc \leqq (Vd + \text{about } 0.7V)$ as described above, a resistance between the input and output terminals A and B is calculated by a parallel combination of the resistance of the PIN diode D and that of the resistance element R1.

If the control voltage Vc is lowered below the divided voltage Vd, the PIN diodes D2 and D3 are biased in the forward direction and turned on, and the cathode of the PIN diode D1 is grounded in a high-frequency fashion by the bypass capacitor C4. In this state, the PIN diode D1 is reverse-biased, and the resistance of the resistance element R1 and the on-resistance of the PIN diode D2 constitute a variable attenuation circuit. In other words, an operation for setting the output level at a required value is performed by an L-shaped attenuator constituted of the resistance element R1 and PIN diode D2. The off-resistance of D1 is thus higher than the resistance of R1 (off-resistance of D1 >> resistance of R1), and the off-resistance of the PIN. diode D1 hardly exerts an effect upon the operation. However, the PIN diode D1 is self-rectified due to a strong input signal and starts to generate a bias variation distortion.

In the first embodiment, the PIN diode D1 is greatly reverse-biased when a strong signal having a level of 0 dBm is input. Therefore, the general-purpose silicon diode D3 is connected in series to the PIN diode D2 through the resistance element R2 to decrease the amount of bias variation distortion due to self-rectification of the PIN diode D1. A reverse bias of about 1.4V is applied to the PIN diode D1 using a drop in forward voltage-down (about 1.4V in both of them) between the anode and cathode of the diodes D2 and D3.

As described above, a low distortion is achieved within a wide range of input levels from the operation start level of AGC to the strong input level of 0 dBm.

(Other Embodiments)

FIGS. 2A to 2C are circuit diagrams of arrangements of variable attenuators according to the other embodiments of the present invention. FIG. 2A shows a circuit arrangement of the variable attenuator according to the second embodiment in which the general-purpose silicon diode D3 is replaced with two diodes D31 and D32 connected in series to each other. FIG. 2B illustrates a circuit arrangement of the variable attenuator according to the third embodiment in which the general-purpose silicon diode D3 is replaced with a Zener diode ZD. FIG. 2C shows a circuit arrangement of the variable attenuator according to the fourth embodiment in which the PIN diode D1 is replaced with two diodes D11 and D12 connected in series to each other.

If the variable attenuators are arranged as shown in FIGS. 2A to 2C, the operation and function of the first embodiment become more conspicuous.

(Experimental Results)

FIGS. 3A and 3B are graphs showing results of actual measurements of tertiary distortions generated from "sample M" and "sample N" when a signal f1 of . 89 MHz and a signal f2 of 90 MHz are input to the "sample M" and "sample N". It is at two frequencies of 88 MHz and 91 MHz that tertiary distortions are actually generated, but FIGS. 3A and 3B show only the tertiary distortion generated at the frequency of 91 MHz.

The "sample M" is an amplifier (gain 10 dB) with an AGC circuit to which the variable attenuator of the present invention is applied, while the "sample N" is an amplifier (gain 5 dB) with an AGC circuit to which a variable attenuator without the features of the present invention.

As apparent from a comparison of FIGS. 3A and 3B, the tertiary distortion of "sample M" with the features of the present invention is greatly decreased as compared with that of "sample N" without the features of the present invention.

**Claims**

**1.** A variable attenuation circuit comprising:

a first diode (D1) connected between an input terminal (A) and an output terminal (B) such that a cathode side thereof is directed to the output terminal (B);

a second diode (D2) connected between the cathode of the first diode (D1) and the ground such that a cathode side thereof is directed to the ground; and

means for applying a control voltage (Vc) so as to variably attenuate a signal level of the output terminal (B) by varying the on-resistance of said first and second diodes (D1, D2);

**characterised in that** the second diode (D2) is connected to the ground through a capacitor (C4), and the attenuation circuit further comprises:

a resistance element (R1) connected in series to a high-frequency capacitor (C2), and both being connected in parallel to the first diode (D1); and

a third diode (D3) connected in series to said second diode (D2) through a further resistance element (R2).

2. A variable attenuation circuit according to claim 1, wherein the third diode (D3) is a silicon diode.

3. A variable attenuation circuit according to claim 1, wherein each of said first and second diodes (D1, D2) is a PIN diode.

4. A variable attenuation circuit according to claim 1, wherein the first diode (D1) includes at least two diodes connected in series.

5. A variable attenuation circuit according to claim 1, wherein said third diode (D3) includes one of at least two diodes and at least two Zener diodes.

6. A variable attenuation circuit according to claim 1, wherein, when the on-resistance of the first diode (D1) is $\Omega D1$, off-resistance thereof is $\Omega D2$, and resistance of the resistance element is $\Omega R1$, the following relationship is satisfied: $\Omega D1 << \Omega R1 < \Omega D2$.

**Patentansprüche**

1. Ein Schaltkreis mit variabler Dämpfung, welcher aufweist:

eine erste Diode (D1), die zwischen einem Eingangsanschluß (A) und einem Ausgangsanschluß (B) derart angeschlossen ist, daß eine Kathodenseite hiervon zu dem Ausgangsanschluß (B) hin gerichtet ist;

eine zweite Diode (D2), die zwischen der Kathode der ersten Diode (D1) und Masse derart angeschlossen ist, daß eine Kathodenseite hiervon zur Masse hin gerichtet ist; und

Mittel zum Anlegen einer Steuerspannung (Vc), um einen Signalpegel des Ausgangsanschlusses (B) durch Variieren des Durchlaßwiderstands der ersten und der zweiten Diode (D1, D2) variabel zu dämpfen;

**dadurch gekennzeichnet, daß** die zweite Diode (D2) durch einen Kondensator (C4) mit Masse verbunden ist und der Schaltkreis mit Dämpfung weiter aufweist:

ein widerstandselement (R1), welches in Reihe mit einem Hochfrequenzkondensator (C2) geschaltet ist, und wobei beide parallel zu der ersten Diode (D1) geschaltet sind; und

eine dritte Diode (D3), welche durch ein weiteres Widerstandselement (R2) in Reihe mit der zweiten Diode (D2) geschaltet ist.

2. Ein Schaltkreis mit variabler Dämpfung gemäß Anspruch 1, wobei die dritte Diode (D3) eine Siliziumdiode ist.

3. Ein Schaltkreis mit variabler Dämpfung gemäß Anspruch 1, wobei sowohl die erste als auch die zweite Diode eine PIN-Diode ist.

4. Ein Schaltkreis mit variabler Dämpfung gemäß Anspruch 1, wobei die erste Diode (D1) wenigstens zwei in Reihe geschaltete Dioden beinhaltet.

5. Ein Schaltkreis mit variabler Dämpfung gemäß Anspruch 1, wobei die dritte Diode (D3) entweder wenigstens zwei Dioden oder wenigstens zwei Zenerdioden beinhaltet.

6. Ein Schaltkreis mit variabler Dämpfung gemäß Anspruch 1, wobei, wenn der Durchlaßwiderstand der ersten Diode (D1) $\Omega D1$ ist, der Sperrwiderstand hiervon $\Omega D2$ ist und der widerstand des Widerstandselements $\Omega R1$ ist, die folgende Beziehung erfüllt ist: $\Omega D1 << \Omega R1 << \Omega D2$.

**Revendications**

1. Circuit atténuateur variable comprenant :

une première diode (D1) connectée entre une borne d'entrée (A) et une borne de sortie (B) de telle sorte que son côté cathode soit dirigé vers la borne de sortie (B) ;

une seconde diode (D2) connectée entre la cathode de la première diode (D1) et la terre, de telle sorte que son côté cathode soit dirigé vers la terre ; et

un moyen pour appliquer une tension de commande (Vc) de manière à atténuer de manière variable un niveau de signal de la borne de sortie (B) en faisant varier la résistance à l'état passant desdites première et seconde diodes (D1, D2) ;

**caractérisé en ce que** la seconde diode (D2) est connectée à la terre par l'intermédiaire d'un condensateur (C4), et **en ce que** le circuit d'atténuation comprend aussi :

un élément de résistance (R1) connecté en série à un condensateur haute fréquence (C2), et tous deux étant connectés en parallèle à la première diode (D1) ; et
une troisième diode (D3) connectée en série à ladite seconde diode (D2) par l'intermédiaire d'un autre élément de résistance (R2).

2. Circuit atténuateur variable selon la revendication 1, dans lequel la troisième diode (D3) est une diode au silicium.

3. Circuit atténuateur variable selon la revendication 1, dans lequel chacune desdites première et seconde diodes (D1, D2) est une diode PIN.

4. Circuit atténuateur variable selon la revendication 1, dans lequel la première diode (D1) comprend au moins deux diodes connectées en série.

5. Circuit atténuateur variable selon la revendication 1, dans lequel ladite troisième diode (D3) comprend une d'au moins deux diodes et au moins deux diodes Zener.

6. Circuit atténuateur variable selon la revendication 1, dans lequel, lorsque la résistance à l'état passant de la première diode (D1) est $\Omega$D1, que sa résistance à l'état non passant est $\Omega$D2, et que la résistance de l'élément de résistance est $\Omega$R1, la relation suivante est satisfaite : $\Omega$D1<< $\Omega$R1< $\Omega$D2.

FIG. 1A

FIG. 1B

FIG. 2A

FIG. 2B

FIG. 2C

INPUT SIGNAL f1=89MHz
            f2=90MHz
OUTPUT TERTIARY
DISTORTION      f3=91MHz

「SAMPLE M」 AMPLIFIER WITH
AGC CIRCUIT (GAIN 10dB)

FIG. 3A

INPUT SIGNAL f1=89MHz
            f2=90MHz
OUTPUT TERTIARY
DISTORTION      f3=91MHz

「SAMPLE N」 AMPLIFIER WITH
AGC CIRCUIT (GAIN 5dB)

FIG. 3B